# EUROPÄISCHE PATENTANMELDUNG

(11) **EP 4 633 122 A1**
(43) Veröffentlichungstag der Anmeldung: **15.10.2025**
(21) Anmeldenummer: 25169551.6
(22) Anmeldetag: 09.04.2025
(51) Int. Cl.: H04M 1/02, H05K 5/00

(54) **UNTERBAUVORRICHTUNG ZUR MONTAGE EINER SPRECHANLAGENEINHEIT AN EINEM UNTERGRUND UND KOMBINATION UMFASSEND EINE SPRECHANLAGENEINHEIT UND DIE UNTERBAUVORRICHTUNG**

(30) Priorität: 09.04.2024 DE 102024109857
(71) Anmelder: Aeromaritime Systembau GmbH, 85375 Neufahrn (DE)
(72) Erfinder: HEFELE, Georg, 85229 Markt Indersdorf (DE); BERANEK, Andreas, 86551 Aichach (DE); MILKEVYCH, Vladimir, 85356 Freising (DE)
(74) Vertreter: Weickmann & Weickmann PartmbB

(57) **Zusammenfassung**

Unterbauvorrichtung zur Montage einer Sprechanlageneinheit (10) an einem Untergrund, wobei die Unterbauvorrichtung als Gehäuse (1) ausgebildet ist, welches eine Befestigungsseite (2) zur Befestigung des Gehäuses (1) an dem Untergrund und eine Halteseite (3) zum Halten der Sprechanlageneinheit (10) an dem Gehäuse (1) aufweist, und wobei die Unterbauvorrichtung eine Aufsetzhilfseinrichtung (8, 11, 12) zum Aufsetzen der Sprechanlageneinheit (10) auf die Halteseite (3) aufweist, wobei zwischen der Befestigungsseite (2) und der Halteseite (3) ein Gehäusehohlraum (4) vorhanden ist, in welchen von außerhalb des Gehäuses (1) wenigstens eine Leitung zur Übertragung von Signalen und/oder Daten und/oder Strom von oder zu der Sprechanlageneinheit (10) geführt ist, wobei die wenigstens eine Leitung einen Steckverbinder (5) zum Verbinden mit einem Gegensteckverbinder (6) an der Sprechanlageneinheit (10) aufweist, wobei auf der Halteseite (3) des Gehäuses (1) eine Zugangsöffnung (7) vorhanden ist, durch welche hindurch der Gehäusehohlraum (4) zugänglich ist, und wobei die Sprechanlageneinheit (10) mittels der Aufsetzhilfseinrichtung (8, 11, 12) derart auf die Halteseite (3) aufsetzbar ist, dass einerseits der Steckverbinder (5) mit dem Gegensteckverbinder (6) passgenau verbunden ist und andererseits die Zugangsöffnung (7) verschlossen ist.

## Beschreibung

### I. Anwendungsgebiet

Die vorliegende Erfindung betrifft eine Unterbauvorrichtung zur Montage einer Sprechanlageneinheit an einem Untergrund. Bei der Sprechanlageneinheit handelt es sich insbesondere um eine maritime Sprechanlageneinheit zur Verwendung auf Schiffen, insbesondere auf Marineschiffen der sogenannten F125 Klasse. Die Erfindung betrifft außerdem eine Kombination umfassend eine Sprechanlageneinheit und die vorgenannte Unterbauvorrichtung.

### II. Technischer Hintergrund

Sprechanlageneinheiten zur Verwendung auf Schiffen, insbesondere Marineschiffen, sind bekannt. Sie werden auch als VCT (Abkürzung für Voice Control Terminal) bezeichnet. Sie werden auf den Schiffen sowohl im Freien bzw. der Außenumgebung als auch in Innenräumen verwendet, um sprachliche Kommunikation zwischen Personen zu ermöglichen, die sich an unterschiedlichen Stellen des Schiffes befinden.

In dem Gehäuse einer Sprechanlageneinheit der bekannten Art befinden sich diverse elektrische bzw. elektronische Bauteile. Durch abgedichtete Gehäuseöffnungen werden in das Innere des Gehäuses elektrische Kabel und Signalleitungen wie beispielsweise Lichtwellenleiter geführt. Innerhalb des Gehäuses werden diese elektrischen Kabel bzw. Signalleitungen über Steckverbindungen an die entsprechenden elektrischen bzw. elektronischen Bauteile angeschlossen.

Im Falle einer Reparatur oder eines erforderlichen Austauschs der bekannten Sprechanlageneinheit ist es erforderlich, ihr Gehäuse zu öffnen, um die Steckverbindungen der elektrischen Kabel bzw. Signalleitungen zu lösen. Dadurch werden sogenannte Manipulationserkennungsplaketten verletzt und die Sprechanlageneinheit muss nach dem Schließen ihres Gehäuses erneut dahingehend vermessen werden, ob ihre geforderte elektromagnetische Abschirmung wieder gewährleistet ist. Des Weiteren muss beim Öffnen einer Sprechanlageneinheit der in Rede stehenden Art immer eine sicherheitszertifizierte Person anwesend sein, die darauf achtet, dass an der geöffneten Sprechanlageneinheit keine Manipulationen beliebiger Art vorgenommen werden.

Das Öffnen der Sprechanlageneinheit an sich, die erneute Vermessung auf elektromagnetische Abschirmwirkung und die Anwesenheit einer sicherheitszertifizierten Person stellen einen erheblichen Aufwand im Rahmen der Wartung, Reparatur und des Austauschs von Sprechanlageneinheiten bekannter Art dar.

### III. Darstellung der Erfindung

### a) Technische Aufgabe

Es ist daher die Aufgabe der vorliegenden Erfindung, eine Unterbauvorrichtung zur Montage einer Sprechanlageneinheit an einem Untergrund sowie eine Kombination umfassend eine Sprechanlageneinheit und die Unterbauvorrichtung zu schaffen, welche die Wartung, die Reparatur und den Austausch von Sprechanlageneinheiten, die insbesondere zur Verwendung auf Marineschiffen vorgesehen sind, mit möglichst geringem Aufwand ermöglichen, d.h. ohne ein Öffnen der Sprechanlageneinheit an sich, ohne die Notwendigkeit eines erneuten Vermessens der elektromagnetischen Abschirmwirkung und ohne die Notwendigkeit der Anwesenheit einer sicherheitszertifizierten Person.

### b) Lösung der Aufgabe

Diese Aufgabe wird mittels einer Unterbauvorrichtung mit den Merkmalen des Anspruchs 1 und mittels einer Kombination mit den Merkmalen des Anspruchs 26 gelöst. Weitere Ausgestaltungen der vorliegenden Erfindung ergeben sich aus den Unteransprüchen.

Erfindungsgemäß wird eine Unterbauvorrichtung zur Montage einer Sprechanlageneinheit an einem Untergrund vorgeschlagen. Bei der Sprechanlageneinheit kann es sich insbesondere um eine nach Marinevorschriften abhörsichere Sprechanlageneinheit bekannter Art handeln. Bei dem Untergrund kann es sich insbesondere um Außen- oder Innenwände auf einem Marineschiff handeln.

Die erfindungsgemäße Unterbauvorrichtung ist als Gehäuse ausgebildet, welches eine Befestigungsseite zur Befestigung des Gehäuses an dem Untergrund und eine Halteseite zum Halten der Sprechanlageneinheit an dem Gehäuse aufweist. Im Gebrauch befindet sich die Unterbauvorrichtung zwischen dem Untergrund und der eigentlichen Sprechanlageneinheit.

Des Weiteren weist die Unterbauvorrichtung eine Aufsetzhilfseinrichtung zum vorzugsweise manuellen Aufsetzen der Sprechanlageneinheit auf die Halteseite des Gehäuses auf.

Zwischen der Befestigungsseite und der Halteseite des Gehäuses ist ein Gehäusehohlraum vorhanden, in welchen von außerhalb des Gehäuses wenigstens eine Leitung oder mehrere Leitungen zur Übertragung von Signalen und/oder Daten und/oder Strom von und/oder zu der Sprechanlageneinheit geführt ist. Dabei weist die wenigstens eine Leitung einen Steckverbinder zum Verbinden mit einem Gegensteckverbinder an der Sprechanlageneinheit auf.

Auf der Halteseite des Gehäuses ist eine Zugangsöffnung vorhanden, durch welche hindurch der Gehäusehohlraum der Unterbauvorrichtung zugänglich ist.

Die Sprechanlageneinheit ist mittels der Aufsetzhilfseinrichtung derart vorzugsweise manuell auf die Halteseite des Gehäuses aufsetzbar, dass einerseits der Steckverbinder mit dem Gegensteckverbinder passgenau verbunden ist und andererseits die Zugangsöffnung durch die Sprechanlageneinheit verschlossen ist.

Bei der erfindungsgemäßen Unterbauvorrichtung ist die Aufsetzhilfseinrichtung derart ausgelegt ist, dass sie beim Aufsetzen der Sprechanlageneinheit auf die Halteseite des Gehäuses dafür sorgt, dass der Steckverbinder passgenau mit dem Gegensteckverbinder an der Sprechanlageneinheit verbunden werden kann. Diese unterbauseitige Aufsetzhilfseinrichtung ist mit einer sprechanlagenseitigen Gegenaufsetzhilfseinrichtung an der Rückseite der Sprechanlageneinheit koppelbar und wirkt beim Aufsetzen der Sprechanlageneinheit auf die Halteseite mit dieser zusammen.

Die erfindungsgemäße Unterbauvorrichtung hat den Vorteil, dass ein Wechsel der Sprechanlageneinheit auf schnelle und einfache Weise möglich ist, indem die Sprechanlageneinheit vorzugsweise von Hand von der Unterbauvorrichtung abgehoben bzw. abgenommen wird. Dabei löst sich der Steckverbinder von dem Gegensteckverbinder und anschließend können ggf. weitere Steckverbindungen von anderen Leitungen als der Leitung zur Übertragung von Signalen und/oder Daten und/oder Strom, die in dem Gehäusehohlraum der Unterbauvorrichtung noch zusammengesteckt sind, gelöst werden. Danach ist die Sprechanlageneinheit nicht mehr über Datenleitungen oder Kabel mit der Unterbauvorrichtung verbunden und kann von der Unterbauvorrichtung entfernt werden.

Das Lösen der Sprechanlageneinheit von der Unterbauvorrichtung erfordert kein Öffnen der Sprechanlageneinheit an sich. Deren Gehäuse bleibt geschlossen und alle sicherheitstechnischen Maßnahmen, wie das erneute Vermessen auf elektromagnetische Abschirmung und die Anwesenheit einer sicherheitszertifizierten Person erübrigen sich.

Die erfindungsgemäße Unterbauvorrichtung wirkt in der Art eines Verteilerkastens. Die üblichen, schiffsseitig vorhandenen Kabel und Leitungen können unverändert verwendet werden. Sie werden nur nicht wie im Stand der Technik in das Innere der Sprechanlageneinheit geführt, sondern stattdessen in den Gehäusehohlraum der Unterbauvorrichtung. Aufgrund der mechanischen Abschirmung der Steckverbindungen innerhalb der durch die Sprechanlageneinheit verschlossenen Unterbauvorrichtung müssen nicht zwingend seewasserfeste Stecker, Buchsen und Kupplungen verwendet werden.

In vorteilhafter Weise weist die Aufsetzhilfseinrichtung wenigstens ein Loch oder wenigstens einen Stift zum Zusammenwirken mit wenigstens einem Stift oder wenigstens einem Loch an der Sprechanlageeinheit auf. Bevorzugt sind genau zwei Löcher oder genau zwei Stifte zum Zusammenwirken mit genau zwei Stiften oder genau zwei Löchern an der Sprechanlageeinheit.

Vorzugsweise umfasst die Aufsetzhilfseinrichtung wenigstens einen Schwenkarm, an welchem die Sprechanlageneinheit mittels einer an ihr angeordneten Halterungseinrichtung halterbar ist. Der Schwenkarm ist zum Aufsetzen der Sprechanlageneinheit auf die Halteseite der Unterbauvorrichtung um eine Schwenkachse von einer Montageposition, in welcher er teilweise durch die Zugangsöffnung hindurch aus dem Gehäuseraum herausragt, in eine Betriebsposition, in welcher er sich in dem Gehäusehohlraum befindet, schwenkbar.

In vorteilhafter Weise ist der Schwenkarm dabei derart mit der Halterungseinrichtung verbindbar, dass die Halterungseinrichtung zum Aufsetzen der Sprechanlageneinheit auf die Halteseite der Unterbauvorrichtung relativ zu dem Schwenkarm einerseits mit einem rotatorischen Freiheitsgrad um eine Montageachse, welche parallel zu der Schwenkachse verläuft, und andererseits mit einem translatorischen Freiheitsgrad bewegbar ist.

Dabei weist der Schwenkarm einen Nutenstein zum Einführen in eine Führungsnut auf, die in der Halterungseinrichtung vorhanden ist. Alternativ kann der Schwenkarm eine Führungsnut aufweisen, in welche ein Nutenstein einführbar ist, der an der Halterungseinrichtung angeordnet ist.

Im Falle der Alternative, dass der Schwenkarm mit einer Führungsnut versehen ist, kann der die Führungsnut aufweisende Schwenkarm eine Riegeleinrichtung aufweisen, die zwischen einer Verriegelungsstellung zum Verriegeln der Führungsnut und einer Entriegelungsstellung zum Entriegeln der Führungsnut bewegbar ist. In der Verriegelungsstellung hält die Riegeleinrichtung den an der Halterungseinrichtung angeordneten Nutenstein, wenn er in die Führungsnut eingeführt ist, formschlüssig in der Führungsnut. In der Entriegelungsstellung ist der an der Haltungseinrichtung angeordnete Nutenstein, wenn er in die Führungsnut eingeführt ist, aus der Führungsnut heraus bewegbar.

Im Falle der Alternative, dass der Schwenkarm einen Nutenstein zum Einführen in eine Führungsnut aufweist, die in der Haltungseinrichtung vorhanden ist, ist die Riegeleinrichtung der voranstehend beschriebenen Art an der Halterungseinrichtung angeordnet, die sich an der Rückseite der Sprechanlageneinheit befindet. Die dort angeordnete Riegeleinrichtung wirkt in derselben Weise wie voranstehend beschrieben.

Der Schwenkarm und die Riegeleinrichtung haben den Vorteil, dass sie ein Herunterschwenken oder Herunterklappen der Sprechanlageneinheit von der Unterbauvorrichtung ermöglichen, wobei gleichzeitig ein sicheres Halten der Sprechanlageneinheit an der Unterbauvorrichtung gewährleistet ist. In ihrer heruntergeklappten Stellung nimmt die Sprechanlageneinheit eine stabile Montagelage ein, in welcher die Rückseite der Sprechanlageneinheit in der Art einer Montagetischplatte verwendet werden kann. An den Leitungen, Kabeln und Kontakten zwischen der Unterbauvorrichtung und der Sprechanlageneinheit kann bequem gearbeitet werden. Ein Lösen und Zusammenstecken der ggf. vorhandenen Steckverbindungen, die sich nicht automatisch beim Abheben bzw. Anbringen der Sprechanlageneinheit von bzw. an der Unterbauvorrichtung lösen bzw. in Eingriff kommen, ist auf bequeme Weise möglich. Die Rückseite der Sprechanlageneinheit kann gegebenenfalls als Ablage für etwaig erforderliche Handwerkzeuge dienen.

Vorzugsweise umfasst die Aufsetzhilfseinrichtung den ersten Schwenkarm und einen zweiten Schwenkarm, an welchen die Sprechanlageneinheit mittels der ersten Halterungseinrichtung und einer zweiten Halterungseinrichtung halterbar ist.

Vorzugsweise ist dabei der zweite Schwenkarm mit der zweiten Halterungseinrichtung derart verbindbar, dass die zweite Halterungseinrichtung zum Aufsetzen der Sprechanlageneinheit auf die Halteseite der Unterbauvorrichtung relativ zu dem zweiten Schwenkarm einerseits mit einem rotatorischen Freiheitsgrad um die Montageachse und andererseits mit einem translatorischen Freiheitsgrad bewegbar ist.

In vorteilhafter Weise kann der zweite Schwenkarm einen zweiten Nutenstein zum Einführen in eine zweite Führungsnut aufweisen, die in der zweiten Halterungseinrichtung vorhanden ist. Alternativ besteht die Möglichkeit, an dem zweiten Schwenkarm eine zweite Führungsnut vorzusehen, in welche ein zweiter Nutenstein einführbar ist, der an der zweiten Halterungseinrichtung angeordnet ist.

Im Falle der Alternative, dass der zweite Schwenkarm eine zweite Führungsnut aufweist, ist der die zweite Führungsnut aufweisende zweite Schwenkarm mit einer zweiten Riegeleinrichtung versehen, die zwischen einer Verriegelungsstellung zum Verriegeln der zweiten Führungsnut und einer Entriegelungsstellung zum Entriegeln der zweiten Führungsnut bewegbar ist. Die zweite Riegeleinrichtung hält in der Verriegelungsstellung den an der zweiten Halterungseinrichtung angeordneten zweiten Nutenstein, wenn er in die zweite Führungsnut eingeführt ist, formschlüssig in der zweiten Führungsnut. In der Entriegelungsstellung ist der an der zweiten Halterungseinrichtung angeordnete zweite Nutenstein, wenn er in die zweite Führungsnut eingeführt ist, aus der zweiten Führungsnut heraus bewegbar.

Im Falle der Alternative, dass der zweite Schwenkarm einen zweiten Nutenstein zum Einführen in eine zweite Führungsnut aufweist, die in der zweiten Haltungseinrichtung vorgesehen ist, befindet sich die zweite Riegeleinrichtung an der zweiten Halterungseinrichtung. Sie funktioniert dort in derselben Weise wie voranstehend beschrieben.

In vorteilhafter Weise können der erste Nutenstein, der an dem ersten Schwenkarm angeordnet ist, und der zweite Nutenstein, der an dem zweiten Schwenkarm angeordnet ist, einander derart zugewandt sein, dass die beiden Schwenkarme mit den beiden Nutensteinen zangenartig in die beiden Führungsnuten eingreifen können, die in den beiden Halterungseinrichtungen vorhanden sind.

Vorzugsweise sind der erste Schwenkarm und der zweite Schwenkarm um dieselbe Schwenkachse schwenkbar.

Insgesamt soll die erfindungsgemäße Unterbauvorrichtung so flach wie möglich sein, um möglichst wenig zwischen dem Untergrund und der Sprechanlageneinheit aufzutragen. Im Vergleich zu der Befestigungsseite und der Halteseite weist die vorzugsweise als im Wesentlichen quaderförmiges Gehäuse ausgebildete Unterbauvorrichtung daher vier relativ kleinflächige Stirnseiten auf. Vorzugsweise sind der erste Schwenkarm an einer ersten Stirnseite des Gehäuses und der zweite Schwenkarm an einer zweiten Stirnseite des Gehäuses schwenkbar gelagert, wobei die erste Stirnseite und die zweite Stirnseite einander gegenüberliegen.

Vorzugsweise weist das Gehäuse wenigstens eine Montageseite auf, an welcher wenigstens eine hervorstehende Montagelasche angeordnet ist, durch welche hindurch die Unterbauvorrichtung mittels wenigstens eines Montageelements, beispielsweise einer Schraube, an dem Untergrund befestigt bar ist. Die wenigstens eine Montagelasche ist dabei außerhalb des Gehäusehohlraums angeordnet. Sie kann in vorteilhafter Weise insbesondere in der Ebene der Befestigungsseite der Unterbauvorrichtung aus der Montageseite herausragen.

In vorteilhafter Weise kann das Gehäuse wenigstens eine Verbindungsseite aufweisen, an welcher wenigstens eine hervorstehende Verbindungslasche angeordnet ist, an welcher die Sprechanlageneinheit in aufgesetztem Zustand mittels wenigstens eines Verbindungselements, beispielsweise einer Schraube, befestigbar ist. Dabei kann das wenigstens eine Verbindungselement die Sprechanlageneinheit durchsetzen und beispielsweise in eine Gewindebohrung eingreifen, welche in der Verbindungslasche vorhanden ist.

Vorzugsweise sind die wenigstens eine Verbindungsseite und die wenigstens eine Montageseite identisch. Die Befestigung der Sprechanlageneinheit an der Unterbauvorrichtung einerseits und die Montage der Unterbauvorrichtung an dem Untergrund andererseits erfolgen in diesem Fall an derselben Seite des Gehäuses.

Vorzugsweise weist das Gehäuse die vorgenannte erste Montageseite und eine zweite Montageseite auf. An der ersten Montageseite ist die vorgenannte wenigstens eine erste Montagelasche und an der zweiten Montageseite ist wenigstens eine zweite Montagelasche angeordnet. Die wenigstens eine zweite Montagelasche steht in derselben Weise aus der zweiten Montageseite hervor wie die erste Montagelasche aus der ersten Montageseite.

Vorzugsweise weist das Gehäuse die vorgenannte erste Verbindungsseite und eine zweite Verbindungsseite auf. An der ersten Verbindungsseite ist die vorgenannte wenigstens eine Verbindungslasche und an der zweiten Verbindungsseite ist wenigstens eine zweite Verbindungslasche angeordnet. Die zweite Verbindungslasche steht in derselben Weise aus der zweiten Verbindungsseite hervor wie die erste Verbindungslasche aus der ersten Verbindungsseite.

In vorteilhafter Weise kann die zweite Verbindungsseite identisch mit der zweiten Montageseite sein. In diesem Fall erfolgt die Befestigung der Sprechanlageneinheit an der Unterbauvorrichtung einerseits und die Montage der Unterbauvorrichtung an dem Untergrund andererseits an derselben zweiten Verbindungsseite des Gehäuses der Unterbauvorrichtung. Vorzugsweise können die erste Montageseite und die zweite Montageseite einander gegenüberliegen. In vorteilhafter Weise können auch die erste Verbindungsseite und die zweite Verbindungsseite einander gegenüberliegen. Einander gegenüberliegende Verbindungsseiten ermöglichen ein bequemes Befestigen bzw. Lösen der Sprechanlageeinheit an bzw. von der Unterbauvorrichtung.

Vorzugsweise entspricht die erste Montageseite der ersten Stirnseite, an welcher der erste Schwenkarm gelagert ist, und die zweite Montageseite der zweiten Stirnseite, an welcher der zweite Schwenkarm gelagert ist. In vorteilhafter Weise kann auch die erste Verbindungsseite der vorgenannten ersten Stirnseite und die zweite Verbindungsseite der vorgenannten zweiten Stirnseite entsprechen.

In vorteilhafter Weise kann eine um die Zugangsöffnung vorzugsweise geschlossen umlaufende Dichtung vorhanden sein. Diese Dichtung dichtet den Gehäusehohlraum der Unterbauvorrichtung bei aufgesetzter und befestigter Sprechanlageneinheit staubund wasserdicht ab. Dabei wird vorzugsweise eine solche Dichtwirkung bewirkt, dass die Erfordernisse der IP-Schutzart IP67 erfüllt sind.

Das Gehäuse der Unterbauvorrichtung kann in vorteilhafter Weise wenigstens ein Druckausgleichsventil aufweisen, mittels welchem ein Druckausgleich zwischen dem Gehäusehohlraum und der das Gehäuse umgebenden Umgebung vorzugsweise automatisch durchführbar ist. Dies ist vorteilhaft, da Luftdruckschwankungen in dem Gehäusehohlraum beispielsweise aufgrund von Erwärmung oder Abkühlung des Gehäuses bei staub- und wasserdichter Abdichtung des Gehäusehohlraums nicht durch die Zugangsöffnung hindurch erfolgen können.

Die vorliegende Erfindung betrifft auch eine Kombination umfassend eine Sprechanlageneinheit und die erfindungsgemäße Unterbauvorrichtung. Dabei ist die Sprechanlageneinheit mittels der Aufsetzhilfseinrichtung derart auf die Halteseite des Gehäuses aufgesetzt, dass einerseits der Steckverbinder der wenigstens einen Leitung mit dem Gegensteckverbinder der Sprechanlageneinheit passgenau verbunden ist und andererseits die Zugangsöffnung durch die Sprechanlageneinheit selbst verschlossen ist. In diesem Zustand und wenigstens teilweise während des Vorgangs des Aufsetzens der Sprechanlageneinheit auf die Unterbauvorrichtung wirkt die unterbauseitige Aufsetzhilfseinrichtung mit einer sprechanlagenseitigen Gegenaufsetzhilfseinrichtung zusammen, indem die Aufsetzhilfseinrichtung und die Gegenaufsetzhilfseinrichtung ineinander eingreifen.

### c) Ausführungsbeispiel

Nachfolgend wird ein Ausführungsbeispiel der vorliegenden Erfindung beispielhaft anhand der beigefügten Zeichnungen beschrieben. Es zeigen:
- Fig. 1:: eine perspektivische Ansicht eines Ausführungsbeispiels der erfindungsgemäßen Unterbauvorrichtung;
- Fig. 2:: eine Aufsicht auf die in Fig. 1 gezeigte Unterbauvorrichtung von rechts vorne;
- Fig. 3:: eine Ansicht auf die in Fig. 2 gezeigte Unterbauvorrichtung von unten;
- Fig. 4:: eine Ansicht auf die in Fig. 2 gezeigte Unterbauvorrichtung von rechts, wobei zusätzlich drei verschiedene Stellungen eines Schwenkarms dargestellt sind;
- Fig. 5:: eine perspektivische Ansicht ähnlich Fig. 1, wobei die Zugangsöffnung der Unterbauvorrichtung mit einem Deckel verschlossen ist;
- Fig. 6:: eine perspektivische Ansicht von schräg oben auf ein Ausführungsbeispiel einer erfindungsgemäßen Kombination umfassend die erfindungsgemäße Unterbauvorrichtung und eine Sprechanlageneinheit, wobei sich die Sprechanlageneinheit in ihrer vollständig von der Unterbauvorrichtung weggeschwenkten Stellung befindet, sodass die Rückseite der Sprechanlageneinheit zu sehen ist;
- Fig. 7:: die in Fig. 6 gezeigte Kombination, wobei die Sprechanlageneinheit an der Unterbauvorrichtung befestigt ist und deren Zugangsöffnung verschließt;
- Fig. 8:: eine perspektivische Ansicht der Kombination aus Fig. 7, wobei die Sprechanlageneinheit von der Unterbauvorrichtung nach links vorne abgehoben wurde;
- Fig. 9:: eine Seitenansicht der in Fig. 8 gezeigten Kombination;
- Fig. 10:: die in Fig. 8 gezeigte Kombination, wobei die Sprechanlageneinheit aus ihrer in Fig. 8 gezeigten Stellung um ca. 45° von der Unterbauvorrichtung weggeschwenkt wurde;
- Fig. 11:: eine Seitenansicht der in Fig. 10 gezeigten Kombination;
- Fig. 12:: die in Fig. 10 gezeigte Kombination, wobei die Sprechanlageneinheit aus ihrer in Fig. 10 gezeigten Stellung um weitere ca. 45° von der Unterbauvorrichtung weggeschwenkt wurde;
- Fig. 13:: eine Seitenansicht der in Figur 12 gezeigten Kombination;
- Fig. 14:: die in Fig. 12 gezeigte Kombination, wobei sich die sprechanlagenseitige Riegeleinrichtung in ihrer Entriegelungsstellung befindet;
- Fig. 15:: eine Seitenansicht der in Fig. 14 gezeigten Kombination;
- Fig. 16:: die in Fig. 14 gezeigte Kombination, wobei die Sprechanlageneinheit nach links vorne von der Unterbauvorrichtung wegbewegt wurde; und
- Fig. 17:: eine Seitenansicht der in Fig. 16 gezeigten Kombination.

In den Zeichnungen kennzeichnen gleiche Bezugszeichen gleiche Teile bzw. Elemente oder unterschiedliche Teile bzw. Elemente mit gleicher Funktion.

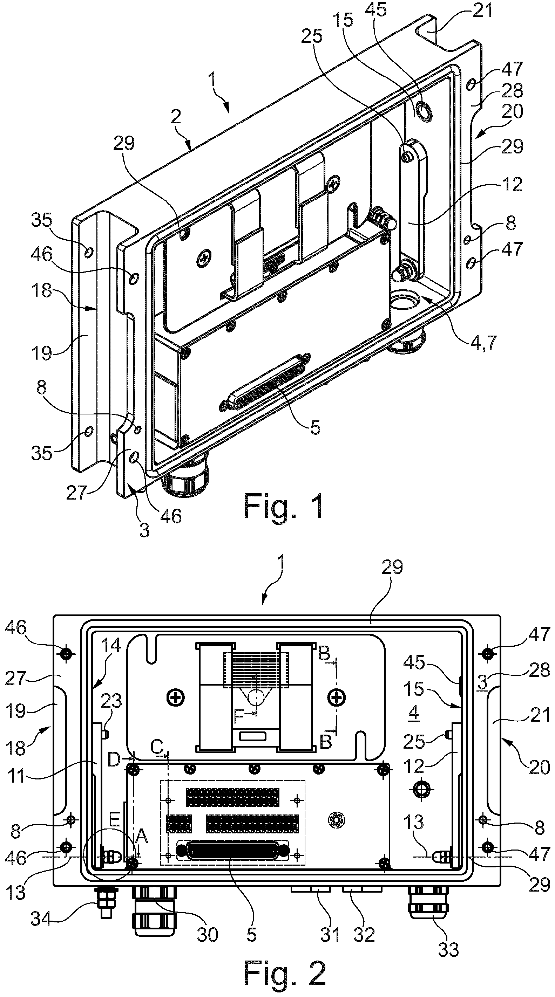

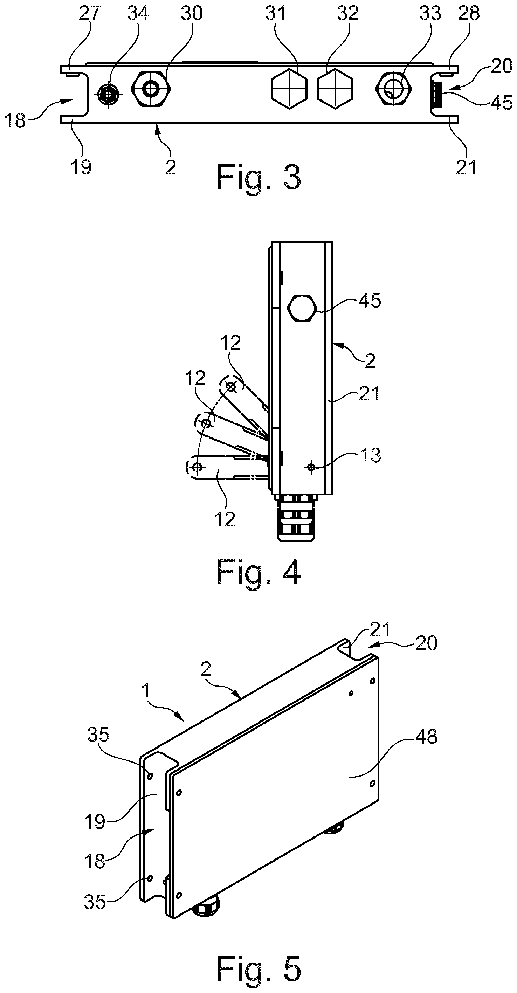

In Fig. 1 ist in perspektivischer Ansicht ein Ausführungsbeispiel einer erfindungsgemäßen Unterbauvorrichtung ohne Sprechanlageneinheit zu sehen. Die Unterbauvorrichtung ist als flaches, quaderförmiges Gehäuse 1 ausgebildet, das in Fig. 1 in der Blickrichtung von rechts vorne eine rechteckige Grundform aufweist. In Fig. 2 ist eine Ansicht der in Fig. 1 gezeigten Unterbauvorrichtung von rechts vorne gezeigt. Die Fig. 3 zeigt eine Ansicht der in Fig. 2 gezeigten Unterbauvorrichtung von unten.

Wie am besten in den Fig. 2 und 3 zu erkennen ist, weist das Gehäuse 1 an seiner Unterseite verschiedene Durchführungseinrichtungen zum Durchführen von Leitungen oder Kabeln von außerhalb des Gehäuses 1 in einen Gehäusehohlraum 4 des Gehäuses 1 auf. Bei den in den Gehäusehohlraum 4 hineinzuführenden Leitungen oder Kabeln handelt es sich um übliche Schiffsleitungen oder Schiffskabel, die im Bereich der Anbringung der Unterbauvorrichtung schiffsseitig vorhanden sind. Diese Schiffsleitungen oder Schiffskabel dienen in an sich bekannter Weise dem Betrieb einer Sprechanlageneinheit der in Rede stehenden Art auf einem Marineschiff. Sie übertragen Signale und/oder Daten und/oder Strom.

Bei der ersten Durchführungseinrichtung 30 handelt es sich um eine Einrichtung zum Durchführen von Strom in den Gehäuseraum 4. Die zweite Durchführeinrichtung 31 dient der Durchführung von Signalen in den Gehäusehohlraum 4. Die dritte Durchführeinrichtung 32 ist zum Durchführen von Signalen und/oder Daten in den Gehäusehohlraum 4 vorgesehen. Bei der vierten Durchführeinrichtung 33 handelt es sich um eine Einrichtung zum Durchführen von Daten in den Gehäusehohlraum 4. In den Fig. 2 und 3 ist links neben der ersten Durchführungseinrichtung 30 ein Erdungsanschluss 34 angeordnet.

Diejenigen Leitungen bzw. Kabel, die durch die Durchführungseinrichtungen 30 und 31 sowie bei Signalen 32 in den Gehäusehohlraum 4 geführt werden, stehen in leitendem Kontakt mit Kontakten eines in dem Gehäusehohlraum 4 unbewegbar befestigten Steckverbinders 5, der in den Fig. 1 und 2 zu sehen ist.

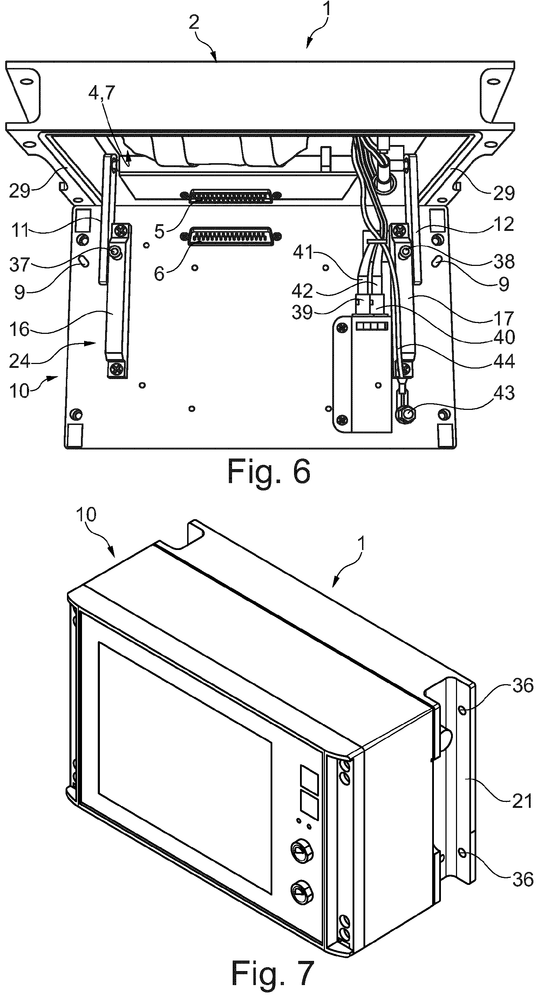

Für einen ordnungsgemäßen Betrieb einer Sprechanlageneinheit 10, die beispielsweise in Fig. 7 zu sehen ist, ist es erforderlich, dass der Steckverbinder 5 zur Signal-, Daten- und/oder Stromübertragung in Steckkontakt mit einem in den Fig. 6, 12 und 14 zu sehenden Gegensteckverbinder 6 an der Rückseite der Sprechanlageneinheit 10 gelangt. Hierzu ist es notwendig, dass die Sprechanlageneinheit 10 derart auf die Unterbauvorrichtung aufgesetzt wird, dass der Steckverbinder 5 exakt mit dem Gegensteckverbinder 6 fluchtet und schließlich die gewünschte Steckverbindung zwischen diesen beiden Verbindern zustande kommt, welche die jeweiligen Kontakte in elektrische Verbindung miteinander bringt.

Die als Gehäuse 1 ausgebildete Unterbauvorrichtung weist eine Befestigungsseite 2 auf, die sich in Fig. 1 links hinten befindet und mit welcher das Gehäuse 1 an einem nicht gezeigten Untergrund befestigt wird. Bei dem Untergrund handelt es sich beispielsweise um eine Wand in einem Außenbereich oder in einem Innenraum eines Marineschiffes. Bei dem gezeigten Ausführungsbeispiel sind an gegenüberliegenden Montageseiten 18 und 20 des Gehäuses 1 Montagelaschen 19 und 21 angeordnet, die entsprechend der Fig. 1 und 3 in entgegengesetzten Richtungen von dem Gehäuse 1 abstehen.

Zur Montage des Gehäuses 1 an einer als Untergrund dienenden Wand weist die erste Montagelasche 19 bei dem gezeigten Ausführungsbeispiel zwei Montagelöcher 35 und die zweite Montagelasche 21 zwei Montagelöcher 36 (siehe Fig. 7) auf. Mit Hilfe nicht gezeigter Montageschrauben kann das Gehäuse 1 durch die Montagelöcher 35 und 36 hindurch an dem Untergrund festgeschraubt werden. Die nach außen hervorstehenden Montagelaschen 19 und 21 sind vorteilhaft, weil sie es ermöglichen, dass die Montagelöcher 35 und 36 das Gehäuse 1 nicht zu dem Gehäusehohlraum 4 hin durchsetzen und dadurch eine ihn umgebende Gehäusewand nicht verletzt wird. Somit entsteht im Hinblick auf die zu erfüllende Staub- und Wasserdichtigkeit gemäß IP-Schutzart IP67 keine Schwachstelle.

Auf der der Befestigungsseite 2 des Gehäuses 1 gegenüberliegenden Seite befindet sich eine Halteseite 3 des Gehäuses 1, die zum Halten der Sprechanlageneinheit 10 an dem Gehäuse 1 dient. Die Halteseite 3 weist bei dem gezeigten Ausführungsbeispiel eine im Wesentlichen rechteckförmige Zugangsöffnung 7 auf, durch welche hindurch der Gehäusehohlraum 4 des Gehäuses 1 zugänglich ist. Wie am besten in den Fig. 1 und 2 zu sehen ist, befindet sich an der Halteseite 3 eine um die Zugangsöffnung 7 umlaufende Dichtung 29, die bei aufgesetzter und befestigter Sprechanlageneinheit 10 den Gehäusehohlraum 4 hermetisch gegenüber der Umgebung des Gehäuses 1 abdichtet.

Die erfindungsgemäße Unterbauvorrichtung weist eine Aufsetzhilfseinrichtung auf, die derart ausgelegt ist, dass sie beim Aufsetzen der Sprechanlageneinheit 10 auf die Halteseite 3 des Gehäuses 1 dafür sorgt, dass der Steckverbinder 5 passgenau mit dem Gegensteckverbinder 6 an der Sprechanlageneinheit 10 verbunden werden kann. Diese unterbauseitige Aufsetzhilfseinrichtung ist mit einer sprechanlagenseitigen Gegenaufsetzhilfseinrichtung an der Rückseite der Sprechanlageneinheit 10 koppelbar und wirkt beim Aufsetzen der Sprechanlageneinheit 10 auf die Halteseite 3 mit dieser zusammen.

Bei dem gezeigten Ausführungsbeispiel der Unterbauvorrichtung umfasst die Aufsetzhilfseinrichtung zwei am besten in den Fig. 1 und 2 zu erkennende Löcher 8 und zwei am besten in den Fig. 1, 2, 4 und 6 zu sehende Schwenkarme, nämlich einen ersten Schwenkarm 11 in den Fig. 2 und 6 links und einen zweiten Schwenkarm 12 in den Fig. 2 und 6 rechts.

Beim Aufsetzen der Sprechanlageneinheit 10 auf die Halteseite 3 wirken die beiden Löcher 8 jeweils mit einem von zwei Stiften 9 zusammen, die an der Rückseite der Sprechanlageneinheit 10 angeordnet und beispielsweise in Fig. 6, 9 und 11 zu erkennen sind. Die Stifte 9 greifen beim Aufsetzen der Sprechanlageneinheit 10 auf die Halteseite 3 jeweils in eines der beiden unterbauseitigen Löcher 8 ein und positionieren dadurch die Sprechanlageneinheit 10 relativ zu der Unterbauvorrichtung derart, dass der Gegensteckverbinder 6 mit dem Steckverbinder 5 fluchtet und passgenau mit ihm in Eingriff gelangt.

Die beiden Schwenkarme 11 und 12 sind innerhalb des Gehäusehohlraums 4 um eine gemeinsame Schwenkachse 13 schwenkbar gelagert, deren Achslinie in Fig. 2 durch den unteren Bereich des Gehäusehohlraums 4 verläuft. Wie am besten in Fig. 2 zu erkennen ist, erfolgt bei dem gezeigten Ausführungsbeispiel die schwenkbare Lagerung des Schwenkarms 11 an der in Fig. 2 links befindlichen Stirnseite 14 des Gehäuses 1 und die schwenkbare Lagerung des zweiten Schwenkarms 12 an der in Fig. 2 rechts befindlichen Stirnseite 15 des Gehäuses 1.

In Fig. 4 sind drei verschiedene Schwenkstellungen des zweiten Schwenkarms 12 dargestellt. In der oberen Schwenkstellung wurde der Schwenkarm 12 um ca. 45° aus seiner in den Fig. 1 und 2 gezeigten Stellung verschwenkt. In der mittleren Schwenkstellung beträgt der Schwenkwinkel aus der in den Fig. 1 und 2 gezeigten Stellung ca. 67,5° und in der unteren Schwenkstellung beträgt der Schwenkwinkel aus der in Fig. 1 und 2 gezeigten Stellung ca. 90°.

Jeder der beiden Schwenkarme 11 und 12 weist an seinem von der Schwenkachse 13 abgewandten Ende einen am besten in Fig. 2 zu erkennenden Nutenstein 23 bzw. 25 auf. Der erste Nutenstein 23 ragt aus dem ersten Schwenkarm 11 heraus in Richtung der gegenüberliegenden Stirnseite 15 des Gehäuses 1. Der zweite Nutenstein 25 ragt aus dem zweiten Schwenkarm 12 heraus in Richtung der gegenüberliegenden Stirnseite 14 des Gehäuses 1. Die beiden Nutensteine 23 und 25 sind somit aufeinander zu gerichtet.

Der grundsätzliche Aufbau und die elektrische bzw. elektronische Funktionsweise der Sprechanlageneinheit 10 der erfindungsgemäßen Kombination sind identisch mit dem Aufbau und der elektrischen bzw. elektronischen Funktionsweise herkömmlicher Sprechanlageneinheiten der in Rede stehenden Art.

Zur Verwendung einer derartigen Sprechanlageneinheit in Zusammenhang mit der als Gehäuse 1 ausgebildeten, erfindungsgemäßen Unterbauvorrichtung ist es lediglich erforderlich, an der Rückseite der Sprechanlageneinheit 10 Änderungen vorzunehmen. Diese Änderungen sind am besten in Fig. 6 erkennbar.

Zum einen ist die Gegenaufsetzhilfseinrichtung vorzusehen, die bei dem gezeigten Ausführungsbeispiel eine erste Halterungseinrichtung 16 mit einer ersten Riegeleinrichtung 37, eine zweite Halterungseinrichtung 17 mit einer zweiten Riegeleinrichtung 38 und die beiden auf der Rückseite der Sprechanlageneinheit 10 hervorstehenden Stifte 9 umfasst. Zum anderen ist der Gegensteckverbinder 6 an der Rückseite der Sprechanlageneinheit 10 für den Steckverbinder 5 frei zugänglich anzuordnen. Des Weiteren sind an der Rückseite der Sprechanlageneinheit 10 weitere Steckverbinder 39 und 40 für weitere Leitungen oder Kabel, hier zwei Lichtwellenleiter 41 und 42, sowie ein Erdungsanschluss 43 zum Anschließen eines Erdungskabels 44 vorzusehen. In dem in Fig. 6 gezeigten Zustand sind die Lichtwellenleiter 41 und 42 sowie das Erdungskabel 44 aus dem Gehäusehohlraum 4 des Gehäuses 1 herausgeführt.

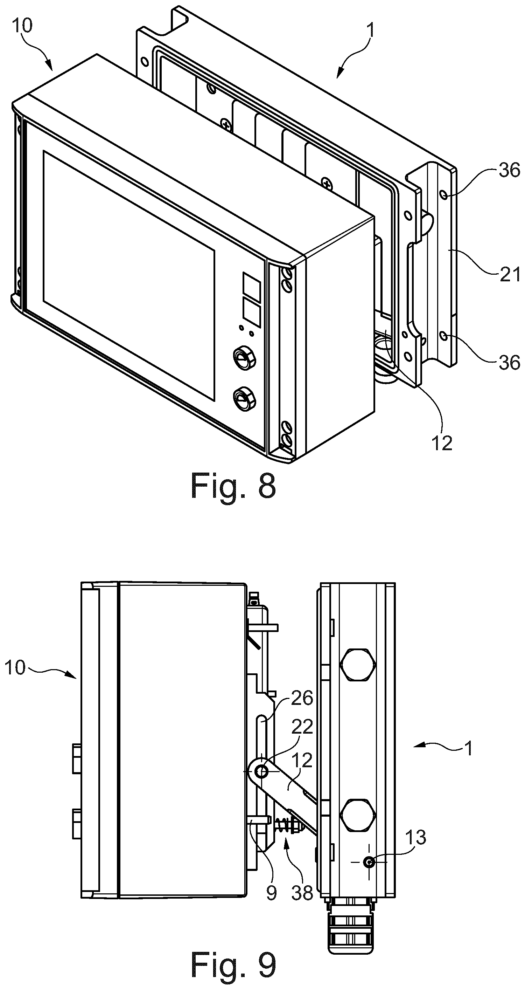

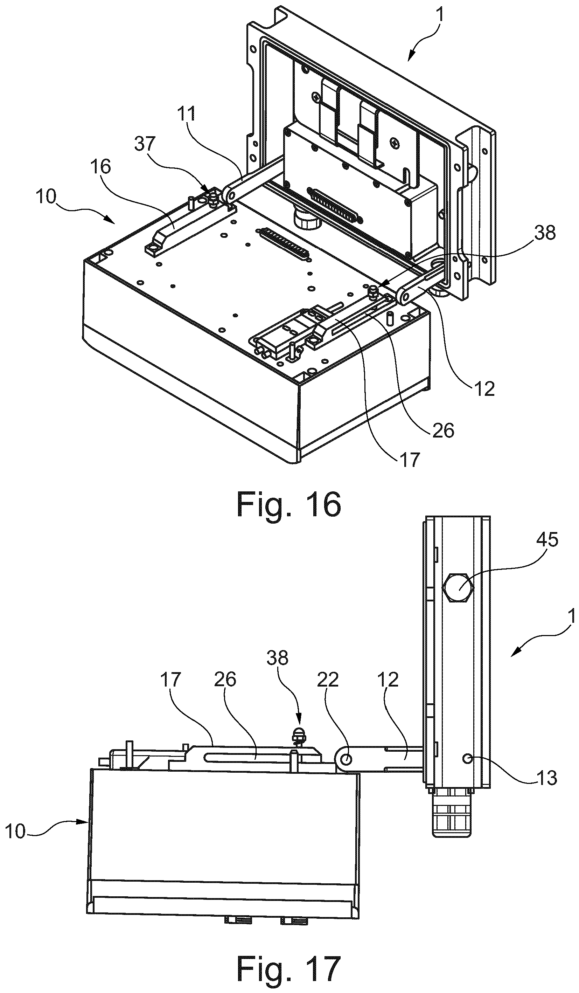

Bei den beiden Halterungseinrichtungen 16 und 17 handelt es sich jeweils um ein längliches Halterungselement, das mit der Rückseite der Sprechanlageneinheit 10 verschraubt ist. Wie in den Fig. 9 bis 17 zu erkennen ist, weist die zweite Halterungseinrichtung 17 eine Führungsnut 26 auf, die in Fig. 9 unten bzw. in Fig. 17 rechts ein offenes Ende aufweist. Im Übrigen ist die Führungsnut 26 entgegen der Blickrichtung der Fig. 9 bzw. in Fig. 6 nach rechts offen. Der Nutenstein 25 an dem Schwenkarm 12 kann durch das in Fig. 17 rechts befindliche, offene Ende der Führungsnut 26 in letztere eingeführt werden.

In analoger Weise wie die zweite Halterungseinrichtung 17 weist die erste Halterungseinrichtung 16 eine Führungsnut 24 auf, die in den Fig. 9 bis 17 allerdings nicht sichtbar ist. Die Lage der Führungsnut 24 ist lediglich durch einen Pfeil in Fig. 6 gekennzeichnet, in welcher sie ebenso nicht sichtbar ist. Die Führungsnut 24 weist an ihrem in Fig. 6 oberen Ende genauso wie die Führungsnut 26 ein offenes Ende auf, durch welches hindurch der Nutenstein 23 an dem Schwenkhebel 11 in die Führungsnut 24 eingeführt werden kann. Die offene Seite der Führungsnut 24 zeigt in Fig. 6 nach links.

Wenn sich der Nutenstein 23 in der Führungsnut 24 und der Nutenstein 25 in der Führungsnut 26 befindet, kann sich die Sprechanlageneinheit 10 während des Vorgangs ihres Aufsetzens auf die Halteseite 3 des Gehäuses 1 relativ zu den beiden Schwenkarmen 11 und 12 bewegen. Diese Relativbewegung ermöglicht einen rotatorischen Freiheitsgrad, d. h. eine Schwenkbewegung der Sprechanlageneinheit 10 um eine Montageachse 22 (siehe Fig. 9, 11 und 13), die durch die Nutensteine 23 und 25 sowie parallel zu der Schwenkachse 13 verläuft, und einen translatorischen Freiheitsgrad, d. h. ein translatorisches Bewegen der Sprechanlageneinheit 10 derart, dass sich die Nutensteine 23 bzw. 25 translatorisch in den hier geradlinig verlaufenden Führungsnuten 24 bzw. 26 linear bewegen. Diese Freiheitsgrade ermöglichen ein passgenaues Aufsetzen der Sprechanlageneinheit 10 auf die Halteseite 3 des Gehäuses 1 derart, dass jeder der beiden Stifte 9 in jeweils eines der beiden Löcher 8 eingreift.

Jeder der beiden Halterungseinrichtungen 16 und 17 ist jeweils eine Riegeleinrichtung 37 und 38 zugeordnet. Wie am besten in den Fig. 6, 9 und 17 zu erkennen ist, befindet sich die Riegeleinrichtung 37 am in Fig. 6 oberen Ende der Halteeinrichtung 16 in der Nähe des offenen Endes der Führungsnut 24. In analoger Weise befindet sich die Riegeleinrichtung 38 am in Fig. 6 oberen Ende der Halteeinrichtung 16 in der Nähe des offenen Endes der Führungsnut 26.

Die Riegeleinrichtungen 37 und 38 dienen dazu, formschlüssig zu verhindern, dass sich der Nutenstein 23 aus der Führungsnut 24 bzw. der Nutenstein 25 aus der Führungsnut 26 herausbewegen kann. Hierzu ist jede der beiden Riegelvorrichtungen 37 und 38 in eine Verriegelungsstellung vorgespannt, in welcher ein jeweiliger Riegelstift die Führungsnut 24 bzw. 26 an der Stelle der Anordnung der Riegeleinrichtung 37 bzw. 38 derart blockiert, dass sich der Nutenstein 23 bzw. 25 nicht über diese Stelle hinweg bewegen kann. Die Nutensteine 23 bzw 25 würden an dem jeweiligen in der Verriegelungsstellung befindlichen Riegelstift anschlagen, wenn versucht würde, sie über die Stelle der Anordnung der Riegeleinrichtung 37 bzw 38 hinweg zu bewegen.

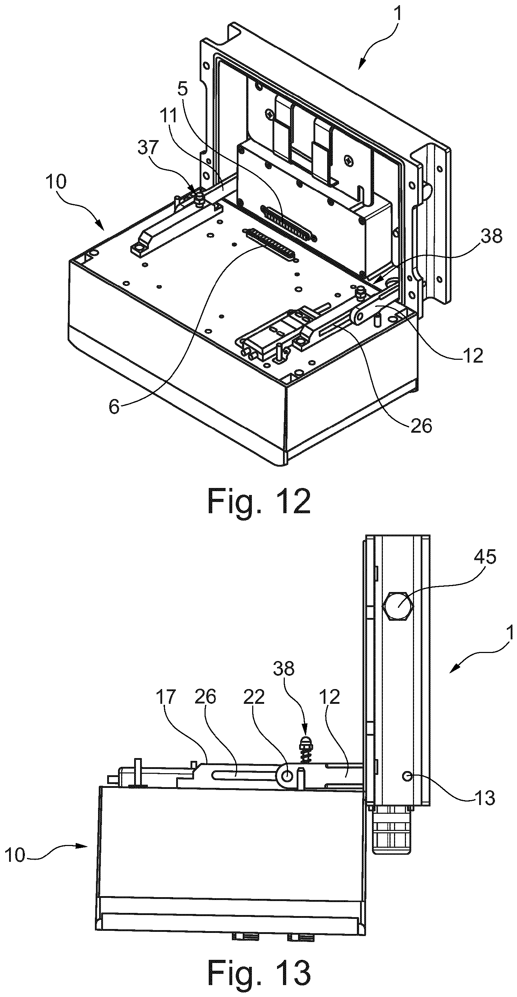

Wie am besten in den Fig. 9 und 13 zu sehen ist, ist die Riegeleinrichtung 38 mittels einer nicht näher gekennzeichneten Druckfeder in ihre Verriegelungsstellung vorgespannt, in welcher sie sich in den Fig. 9 und 13 befindet. Dasselbe gilt für die Riegeleinrichtung 37.

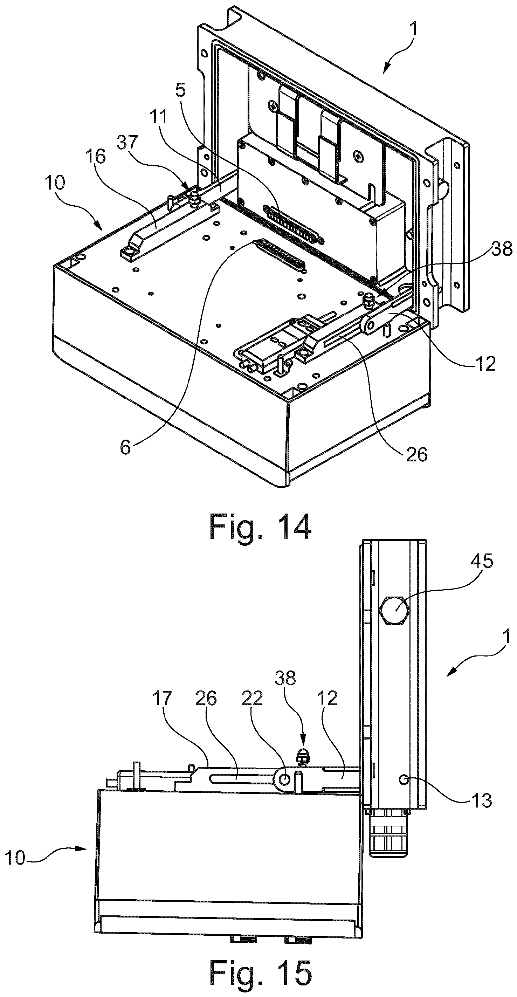

Die Riegeleinrichtung 38 kann in ihre in den Fig. 15 und 17 gezeigte Entriegelungsstellung bewegt werden, indem in ihrer in den Figuren 9 und 13 zu sehenden Verriegelungsstellung entgegen der Vorspannkraft der Druckfeder der nicht weiter gekennzeichnete Riegelstift in Fig, 13 nach unten gedrückt wird. Es bewegt sich dann eine nicht gezeigte Aussparung an dem Riegelstift derart in die Führungsnut 26 hinein, dass der zuvor formschlüssig blockierte Querschnitt der Führungsnut 26 an der Stelle der Anordnung der Riegeleinrichtung 38 dadurch freigegeben wird, dass die vorgenannte Aussparung an dem Riegelstift mit dem Querschnitt der Führungsnut 26 fluchtet. Der Nutenstein 25 kann dann aus der Führungsnut 26 heraus oder in diese hinein bewegt werden. Dasselbe gilt im Hinblick auf die Riegeleinrichtung 37, die Führungsnut 24 und den Nutenstein 23.

Zum sicheren Halten der Sprechanlageneinheit 10 an der als Gehäuse 1 ausgebildeten Unterbauvorrichtung und zum staub- und wasserdichten Abdichten des Gehäusehohlraums 4 gegenüber der Umgebung kann die Sprechanlageneinheit 10 mit Hilfe von Verbindungslaschen 27 und 28 an der Unterbauvorrichtung befestigt werden. Wie am besten in den Fig. 1 und 3 zu sehen ist, steht die erste Verbindungslasche 27 von einer ersten Verbindungsseite 18 des Gehäuses 1 hervor, während die zweite Verbindungslasche 28 von einer zweiten Verbindungsseite 20 des Gehäuses 1 hervorsteht.

Bei dem gezeigten Ausführungsbeispiel weist die erste Verbindungslasche 27 zwei Verbindungslöcher 46 auf, während die zweite Verbindungslasche 28 mit zwei Verbindungslöchern 47 versehen ist. Wie in den Fig. 1 und 2 zu sehen ist, weisen die Verbindungslaschen 27 und 28 bei dem gezeigten Ausführungsbeispiel jeweils eine mittig angeordnete und nicht näher gekennzeichnete Aussparung auf, um beim Abnehmen der Sprechanlageneinheit 10 das Hintergreifen derselben mit den Fingerspitzen der Hände zu erleichtern.

Bei den Verbindungslöchern 46 und 47 handelt es sich vorzugsweise um Gewindebohrungen. Mit Hilfe nicht näher gekennzeichneter Verbindungsschrauben kann die Sprechanlageneinheit 10 fest mit den Verbindungslaschen 27 und 28 verschraubt werden. Dabei wird die Dichtung 29 komprimiert und die hermetische Abdichtung des Gehäusehohlraums 4 gewährleistet.

Insbesondere Schwankungen in der Umgebungstemperatur können bei hermetisch abgedichtetem Gehäusehohlraum 4 dazu führen, dass in letzterem ein Über- oder Unterdruck entsteht. Dieser kann sich nachteilig beim Lösen der Sprechanlageneinheit 10 von der Unterbauvorrichtung auswirken. Im Falle eines Unterdrucks kann beispielsweise das Abheben der Sprechanlageneinheit 10 von der Unterbauvorrichtung erschwert sein. Um eine derartige Über- oder Unterdruckentstehung in dem Gehäusehohlraum 4 zu vermeiden, weist das gezeigte Ausführungsbeispiel in der Stirnseite 15 des Gehäuses 1 ein staub- und wasserdichtes Druckausgleichsventil 45 auf, welches automatisch dafür sorgt, dass sich in dem Gehäusehohlraum 4 derselbe Luftdruck einstellt wie in der Umgebung des Gehäuses 1.

Nachfolgend wird anhand der Fig. 7 bis 17 erläutert, wie ein Austausch der Sprechanlageneinheit 10 mit Hilfe der vorliegenden Erfindung erfolgt.

In dem in Fig. 7 gezeigten Ausgangszustand ist die Sprechanlageneinheit 10 fest mit der als Gehäuse 1 ausgebildeten Unterbauvorrichtung verbunden, d. h. mit den Verbindungslaschen 27 und 28 verschraubt. In diesem betriebsbereiten Zustand der Kombination aus Unterbauvorrichtung und Sprechanlageneinheit 10 greifen der Steckverbinder 5 und der Gegensteckverbinder 6 ineinander ein, die Lichtwellenleiter 41 und 42 sind mit den zugehörigen Steckverbindern 39 und 40 an der Sprechanlageneinheit 10 verbunden und das Erdungskabel 44 ist mit dem Erdungsanschluss 43 verbunden.

Nach dem Lösen der in die Verbindungslöcher 46 und 47 eingreifenden Verbindungsschrauben kann die Sprechanlageneinheit 10 links und rechts mit jeweils einer Hand ergriffen und in Fig. 7 nach links vorne von der Unterbauvorrichtung weggezogen werden. Dabei entfernen sich die beiden Stifte 9 aus den beiden unterbauseitigen Löchern 8 und es wird der in den Fig. 8 und 9 gezeigte Zustand erreicht, in welchem sich die Rückseite der Sprechanlageneinheit 10 in paralleler Ausrichtung zu der Unterbauvorrichtung befindet. Wie in Fig. 9 zu sehen ist, hat sich der Schwenkarm 12 durch eine Schwenkbewegung um ca. 45° um die Schwenkachse 13 aus dem Gehäusehohlraum 4 herausbewegt. Dasselbe gilt für den Schwenkarm 11.

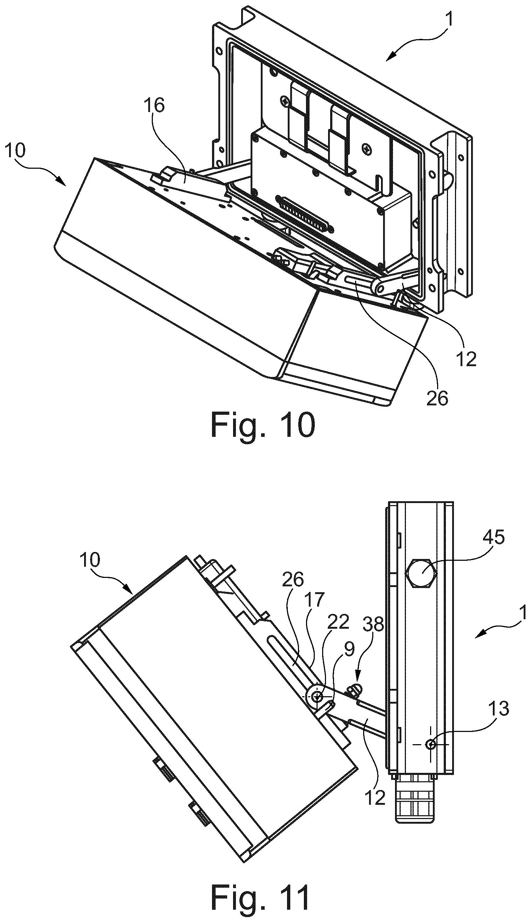

Anschließend kann die Sprechanlageneinheit 10 in Fig. 9 um ca. 45° im Gegenuhrzeigersinn um die Montageachse 22 verschwenkt werden. Dadurch wird der in den Fig. 10 und 11 gezeigte Zustand erreicht. Beim Übergang von dem Zustand gemäß der Fig. 8 und 9 in den Zustand gemäß der Fig. 10 und 11 hat sich der Schwenkarm 12 ebenso wie der Schwenkarm 11 noch etwas weiter aus dem Gehäusehohlraum 4 herausgedreht.

In der weiteren Folge kann die Sprechanlageneinheit 10 ausgehend von ihrer in Fig. 11 zu sehenden Stellung um weitere ca. 45° im Gegenuhrzeigersinn um die Montageachse 22 geschwenkt werden. Dadurch wird der in den Fig. 12 und 13 gezeigte Zustand erreicht, in welchem die Rückseite der Sprechanlageneinheit 10 eine in etwa horizontale Lage einnimmt und der Schwenkarm 12 ebenso wie der Schwenkarm 11 um insgesamt ca. 90° aus dem Gehäusehohlraum 4 des Gehäuses 1 herausgeschwenkt ist.

Die Steckverbindung zwischen dem Steckverbinder 5 und dem Gegensteckverbinder 6 wurde bereits bei dem Übergang von dem Zustand gemäß Fig. 7 in den Zustand gemäß der Fig. 8 und 9 ohne zusätzliche handwerkliche Maßnahmen gelöst. In dem in den Fig. 12 und 13 erreichten Zustand sind jedoch noch die in Fig. 6 gezeigten Lichtwellenleiter 41 und 42 mit ihren zugehörigen Steckverbindern 39 und 40 und das in Fig. 6 gezeigte Erdungskabel 44 mit dem Erdungsanschluss 43 an der Sprechanlage 110 verbunden. Vorgenannte Lichtwellenleiter 41 und 42, Steckverbinder 39 und 40 sowie vorgenanntes Erdungskabel 44 und vorgenannter Erdungsanschluss 43 sind in den Fig. 8 bis 17 aus Gründen der zeichnerischen Vereinfachung nicht dargestellt.

In dem Zustand gemäß Fig. 12 und 13 können nun die Lichtwellenleiter 41 und 42 bequem von den zugehörigen Steckverbindern 39 und 40 gelöst werden. In ebenso bequemer Weise kann das Erdungskabel 44 von dem Erdungsanschluss 43 gelöst werden. Für diese Arbeiten stehen beide Hände der den Austausch der Sprechanlageneinheit 10 vornehmenden Person zur Verfügung. Die Sprechanlageneinheit 10 wird in dem Zustand gemäß Fig. 12 und 13 in der Art einer heruntergeklappten Tischplatte sicher an den Schwenkarmen 11 und 12 und somit an der Unterbauvorrichtung bzw. dem Untergrund gehalten. Auch sonstige Arbeiten, die ggf. zusätzlich in dem Gehäusehohlraum 4 vorzunehmen sind, können auf bequeme Weise mit beiden Händen erledigt werden.

Nach dem Trennen aller Daten-, Signal- und Stromleitungen, welche die Sprechanlageneinheit 10 mit der Unterbauvorrichtung verbunden haben, kann die Sprechanlageneinheit 10 von den Schwenkarmen 11 und 12 gelöst werden. Hierzu kann die Sprechanlageneinheit 10 in dem Zustand gemäß Fig. 12 und 13 links und rechts von jeweils einer Hand derart umgriffen werden, dass sich der jeweilige Daumen oberhalb der Rückseite der Sprechanlageneinheit 10 befindet.

Mit den beiden Daumen können dann gleichzeitig die beiden Riegeleinrichtungen 37 und 38 betätigt werden, indem der jeweilige Riegelstift entgegen der Vorspannung der Druckfeder in den Fig. 12 und 13 nach unten gedrückt wird. Dadurch werden die beiden Führungsnuten 24 und 26 in den Halteeinrichtungen 16 und 17 entriegelt und der in den Fig. 14 und 15 gezeigte Zustand ist erreicht. Die Fig. 14 und 15 unterscheiden sich von den Fig. 12 und 13 lediglich dadurch, dass sich die Riegelstifte der Riegeleinrichtungen 37 und 38 weiter nach unten von ihrer Verriegelungsstellung gemäß der Fig. 12 und 13 in ihre Entriegelungsstellung gemäß der Fig. 14 und 15 bewegt haben.

Schließlich kann dann bei niedergedrückten Riegeleinrichtungen 37 und 38 die Sprechanlageneinheit 10 in Fig. 15 nach links von den Schwenkarmen 11 und 12 abgezogen werden. Es wird dadurch der in den Fig. 16 und 17 gezeigte Zustand erreicht. Die Sprechanlageneinheit 10 ist jetzt vollständig von der als Gehäuse 1 ausgebildeten Unterbauvorrichtung gelöst und kann durch eine andere Sprechanlageneinheit 10 ausgetauscht werden. Der Vorgang des Befestigens und Anschließens der anderen Sprechanlageneinheit 10 kann in exakt umgekehrter Reihenfolge wie voranstehend beschrieben erfolgen.

Wie sich aus der Beschreibung des Vorgangs des Austauschens der Sprechanlageneinheit 10 ergibt, erlaubt es die vorliegende Erfindung, sowohl die auszutauschende Sprechanlageneinheit 10 als auch die andere Sprechanlageneinheit 10 vollkommen ungeöffnet zu lassen. Die andere Sprechanlageneinheit 10 kann einfach im Sinne eines Ersatzteils aus einem Lager entnommen und an der erfindungsgemäßen Unterbauvorrichtung angebracht werden. Eine Neuvermessung im Hinblick auf die elektromagnetische Abschirmwirkung sowie die Anwesenheit einer sicherheitszertifizierten Person sind in vorteilhafter Weise nicht erforderlich.

Steht aus irgendeinem Grund nicht sofort eine andere Sprechanlageneinheit 10 zum Austauschen der abmontierten Sprechanlageneinheit 10 zur Verfügung, kann die Zugangsöffnung 7 der als Gehäuse 1 ausgebildeten Unterbauvorrichtung gemäß Fig. 5 durch einen Deckel 48 staub- und wasserdicht verschlossen werden, sodass der Gehäusehohlraum 4 bis zur späteren Montage der anderen Sprechanlageneinheit 10 vor Umgebungseinflüssen geschützt ist.

### BEZUGSZEICHENLISTE

- 1: Gehäuse
- 2: Befestigungsseite des Gehäuses 1
- 3: Halteseite des Gehäuses 1
- 4: Gehäusehohlraum
- 5: Steckverbinder der Unterbauvorrichtung
- 6: Gegensteckverbinder der Sprechanlageneinheit 10
- 7: Zugangsöffnung auf der Halteseite 3
- 8: Loch
- 9: Stift
- 10: Sprechanlageneinheit
- 11: Erster Schwenkarm
- 12: Zweiter Schwenkarm
- 13: Schwenkachse der Schwenkarme 11, 12
- 14: Erste Stirnseite des Gehäuses 1
- 15: Zweite Stirnseite des Gehäuses 1
- 16: Erste Halterungseinrichtung an der Sprechanlageneinheit 10
- 17: Zweite Halterungseinrichtung an der Sprechanlageneinheit 10
- 18: Erste Montageseite/Verbindungsseite des Gehäuses 1
- 19: Erste Montagelasche
- 20: Zweite Montageseite/Verbindungsseite des Gehäuses 1
- 21: Zweite Montagelasche
- 22: Montageachse
- 23: Erster Nutenstein an dem Schwenkarm 11
- 24: Erste Führungsnut in Halteeinrichtung 16
- 25: Zweiter Nutenstein an dem Schwenkarm 12
- 26: Zweite Führungsnut in Halteeinrichtung 17
- 27: Erste Verbindungslasche
- 28: Zweite Verbindungslasche
- 29: Dichtung
- 30: Erste Durchführungseinrichtung
- 31: Zweite Durchführungseinrichtung
- 32: Dritte Durchführungseinrichtung
- 33: Vierte Durchführungseinrichtung
- 34: Erdungsanschluss
- 35: Montagelöcher in Montagelasche 19
- 36: Montagelöcher in Montagelasche 21
- 37: Erste Riegeleinrichtung
- 38: Zweite Riegeleinrichtung
- 39: Steckverbinder für Lichtwellenleiter 41
- 40: Steckverbinder für Lichtwellenleiter 42
- 41: Lichtwellenleiter
- 42: Lichtwellenleiter
- 43: Erdungsanschluss für Erdungskabel 44
- 44: Erdungskabel
- 45: Druckausgleichsventil
- 46: Verbindungslöcher in Verbindungslasche 27
- 47: Verbindungslöcher in Verbindungslasche 28
- 48: Deckel

## Patentansprüche

1. Unterbauvorrichtung zur Montage einer Sprechanlageneinheit (10) an einem Untergrund,
**dadurch gekennzeichnet, dass**
die Unterbauvorrichtung als Gehäuse (1) ausgebildet ist, welches
• eine Befestigungsseite (2) zur Befestigung des Gehäuses (1) an dem Untergrund und
• eine Halteseite (3) zum Halten der Sprechanlageneinheit (10) an dem Gehäuse (1)
aufweist, und
die Unterbauvorrichtung eine Aufsetzhilfseinrichtung (8, 11, 12) zum Aufsetzen der Sprechanlageneinheit (10) auf die Halteseite (3) aufweist,
• wobei zwischen der Befestigungsseite (2) und der Halteseite (3) ein Gehäusehohlraum (4) vorhanden ist, in welchen von außerhalb des Gehäuses (1) wenigstens eine Leitung zur Übertragung von Signalen und/oder Daten und/oder Strom von oder zu der Sprechanlageneinheit (10) geführt ist, wobei die wenigstens eine Leitung einen Steckverbinder (5) zum Verbinden mit einem Gegensteckverbinder (6) an der Sprechanlageneinheit (10) aufweist,
• wobei auf der Halteseite (3) des Gehäuses (1) eine Zugangsöffnung (7) vorhanden ist, durch welche hindurch der Gehäusehohlraum (4) zugänglich ist, und
• wobei die Sprechanlageneinheit (10) mittels der Aufsetzhilfseinrichtung (8, 11, 12) derart auf die Halteseite (3) aufsetzbar ist, dass einerseits der Steckverbinder (5) mit dem Gegensteckverbinder (6) passgenau verbunden ist und andererseits die Zugangsöffnung (7) verschlossen ist.

2. Unterbauvorrichtung nach Anspruch 1,
**dadurch gekennzeichnet, dass**
die Aufsetzhilfseinrichtung wenigstens ein Loch (8) oder wenigstens einen Stift zum Zusammenwirken mit wenigstens einem Stift (9) oder wenigstens einem Loch an der Sprechanlageneinheit (10) aufweist.

3. Unterbauvorrichtung nach Anspruch 1 oder 2,
**dadurch gekennzeichnet, dass**
die Aufsetzhilfseinrichtung wenigstens einen Schwenkarm (11) umfasst, an welchem die Sprechanlageneinheit (10) mittels einer an ihr angeordneten Halterungseinrichtung (16) halterbar ist und welcher zum Aufsetzen der Sprechanlageneinheit (10) auf die Halteseite (3) um eine Schwenkachse (13) von einer Montageposition, in welcher er teilweise durch die Zugangsöffnung (7) hindurch aus dem Gehäusehohlraum (4) herausragt, in eine Betriebsposition, in welcher er sich in dem Gehäusehohlraum (4) befindet, schwenkbar ist.

4. Unterbauvorrichtung nach Anspruch 3,
**dadurch gekennzeichnet, dass**
der Schwenkarm (11) mit der Halterungseinrichtung (16) derart verbindbar ist, dass die Halterungseinrichtung (16) zum Aufsetzen der Sprechanlageneinheit (10) auf die Halteseite (3) relativ zu dem Schwenkarm (11) mit einem rotatorischen Freiheitsgrad um eine Montageachse (22), welche parallel zu der Schwenkachse (13) verläuft, und mit einem translatorischen Freiheitsgrad bewegbar ist.

5. Unterbauvorrichtung nach Anspruch 4,
**dadurch gekennzeichnet, dass**
der Schwenkarm (11) einen Nutenstein (23) zum Einführen in eine Führungsnut (24) aufweist, die in der Halterungseinrichtung (16) vorhanden ist, oder der Schwenkarm (11) eine Führungsnut aufweist, in welche ein Nutensteineinführbar ist, der an der Halterungseinrichtung angeordnet ist.

6. Unterbauvorrichtung nach Anspruch 5,
**dadurch gekennzeichnet, dass**
der die Führungsnut aufweisende Schwenkarm (11) eine Riegeleinrichtung aufweist, die zwischen einer Verriegelungsstellung zum Verriegeln der Führungsnut und einer Entriegelungsstellung zum Entriegeln der Führungsnut bewegbar ist, wobei sie in der Verriegelungsstellung den an der Halterungseinrichtung angeordnetenNutenstein, wenn er in die Führungsnut eingeführt ist, formschlüssig in der Führungsnut hält und in der Entriegelungsstellung der an der Halterungseinrichtung angeordnete Nutenstein, wenn er in die Führungsnut eingeführt ist, aus der Führungsnut herausbewegbar ist.

7. Unterbauvorrichtung nach einem der Ansprüche 3 bis 6,
**dadurch gekennzeichnet, dass**
die Aufsetzhilfseinrichtung den ersten Schwenkarm (11) und einen zweiten Schwenkarm (12) umfasst, an welchen die Sprechanlageneinheit (10) mittels der ersten Halterungseinrichtung (16) und einer zweiten Halterungseinrichtung (17) halterbar ist.

8. Unterbauvorrichtung nach Anspruch 7 in Verbindung mit Anspruch 4,
**dadurch gekennzeichnet, dass**
der zweite Schwenkarm (12) mit der zweiten Halterungseinrichtung (17) derart verbindbar ist, dass die zweite Halterungseinrichtung (17) zum Aufsetzen der Sprechanlageneinheit (10) auf die Halteseite (3) relativ zu dem zweiten Schwenkarm (12) mit einem rotatorischen Freiheitsgrad um die Montageachse (22) und mit einem translatorischen Freiheitsgrad bewegbar ist.

9. Unterbauvorrichtung nach Anspruch 8,
**dadurch gekennzeichnet, dass**
der zweite Schwenkarm (12) einen zweiten Nutenstein (25) zum Einführen in eine zweite Führungsnut (26) aufweist, die in der zweiten Halterungseinrichtung (17) vorhanden ist, oder der zweite Schwenkarm (12) eine zweite Führungsnut aufweist, in welche ein zweiter Nutenstein einführbar ist, der an der zweiten Halterungseinrichtung angeordnet ist.

10. Unterbauvorrichtung nach Anspruch 9,
**dadurch gekennzeichnet, dass**
der die zweite Führungsnut aufweisende zweite Schwenkarm (12) eine zweite Riegeleinrichtung aufweist, die zwischen einer Verriegelungsstellung zum Verriegeln der zweiten Führungsnut und einer Entriegelungsstellung zum Entriegeln der zweiten Führungsnut bewegbar ist, wobei sie in der Verriegelungsstellung den an der zweiten Halterungseinrichtung angeordneten zweiten Nutenstein, wenn er in die zweite Führungsnut eingeführt ist, formschlüssig in der zweiten Führungsnut hält und in der Entriegelungsstellung der an der zweiten Halterungseinrichtung angeordnete zweite Nutenstein, wenn er in die zweite Führungsnut eingeführt ist, aus der zweiten Führungsnut herausbewegbar ist.

11. Unterbauvorrichtung nach Anspruch 9 in Verbindung mit Anspruch 5,
**dadurch gekennzeichnet, dass**
der erste Nutenstein (23), der an dem ersten Schwenkarm (11) angeordnet ist, und der zweite Nutenstein (25), der an dem zweiten Schwenkarm (12) angeordnet ist, einander derart zugewandt sind, dass die beiden Schwenkarme (11, 12) mit den beiden Nutensteinen (23, 25) zangenartig in die beiden Führungsnuten (24, 26) eingreifen können, die in den beiden Halterungseinrichtungen (16, 17) vorhanden sind.

12. Unterbauvorrichtung nach Anspruch 7,
**dadurch gekennzeichnet, dass**
der erste Schwenkarm (11) und der zweite Schwenkarm (12) um die Schwenkachse (13) schwenkbar sind.

13. Unterbauvorrichtung nach Anspruch 7 oder 12,
**dadurch gekennzeichnet, dass**
der erste Schwenkarm (11) an einer ersten Stirnseite (14) des Gehäuses (1) und der zweite Schwenkarm (12) an einer zweiten Stirnseite (15) des Gehäuses (1) schwenkbar gelagert sind, wobei die erste Stirnseite (14) und die zweite Stirnseite (15) einander gegenüberliegen.

14. Unterbauvorrichtung nach einem der vorangehenden Ansprüche,
**dadurch gekennzeichnet, dass**
das Gehäuse (1) wenigstens eine Montageseite (18) aufweist, an welcher wenigstens eine hervorstehende Montagelasche (19) angeordnet ist, durch welche hindurch die Unterbauvorrichtung mittels wenigstens eines Montageelements an dem Untergrund befestigbar ist, wobei die wenigstens eine Montagelasche (19) außerhalb des Gehäusehohlraums (4) angeordnet ist.

15. Unterbauvorrichtung nach einem der vorangehenden Ansprüche,
**dadurch gekennzeichnet, dass**
das Gehäuse (1) wenigstens eine Verbindungsseite (18) aufweist, an welcher wenigstens eine hervorstehende Verbindungslasche (27) angeordnet ist, an welcher die Sprechanlageneinheit (10) in aufgesetztem Zustand mittels wenigstens eines Verbindungselements befestigbar ist.

16. Unterbauvorrichtung nach Anspruch 15 in Verbindung mit Anspruch 14,
**dadurch gekennzeichnet, dass**
die Verbindungsseite (18) identisch mit der Montageseite (18) ist.

17. Unterbauvorrichtung nach Anspruch 14 oder 16,
**dadurch gekennzeichnet, dass**
das Gehäuse (1) die erste Montageseite (18) und eine zweite Montageseite (20) aufweist, wobei an der ersten Montageseite (18) die wenigstens eine erste Montagelasche (19) und an der zweiten Montageseite (20) wenigstens eine zweite Montagelasche (21) angeordnet sind.

18. Unterbauvorrichtung nach Anspruch 15 oder 16,
**dadurch gekennzeichnet, dass**
das Gehäuse (1) die erste Verbindungsseite (18) und eine zweite Verbindungsseite (20) aufweist, wobei an der ersten Verbindungsseite (18) die wenigstens eine erste Verbindungslasche (27) und an der zweiten Verbindungsseite (20) wenigstens eine zweite Verbindungslasche (28) angeordnet sind.

19. Unterbauvorrichtung nach Anspruch 18 in Verbindung mit Anspruch 17,
**dadurch gekennzeichnet, dass**
die zweite Verbindungsseite (20) identisch mit der zweiten Montageseite (20) ist.

20. Unterbauvorrichtung nach Anspruch 17,
**dadurch gekennzeichnet, dass**
die erste Montageseite (18) und die zweite Montageseite (20) einander gegenüberliegen.

21. Unterbauvorrichtung nach Anspruch 18,
**dadurch gekennzeichnet, dass**
die erste Verbindungsseite (18) und die zweite Verbindungsseite (20) einander gegenüberliegen.

22. Unterbauvorrichtung nach Anspruch 20 in Verbindung mit Anspruch 13,
**dadurch gekennzeichnet, dass**
die erste Montageseite (18) der ersten Stirnseite (14) entspricht und die zweite Montageseite (20) der zweiten Stirnseite (15) entspricht.

23. Unterbauvorrichtung nach Anspruch 21 in Verbindung mit Anspruch 13,
**dadurch gekennzeichnet, dass**
die erste Verbindungsseite (18) der ersten Stirnseite (14) entspricht und die zweite Verbindungsseite (20) der zweiten Stirnseite (15) entspricht.

24. Unterbauvorrichtung nach einem der vorangehenden Ansprüche,
**dadurch gekennzeichnet, dass**
eine um die Zugangsöffnung (7) umlaufende Dichtung (29) vorhanden ist, welche den Gehäusehohlraum (4) bei aufgesetzter und befestigter Sprechanlageneinheit (10) staub- und wasserdicht abdichtet.

25. Unterbauvorrichtung nach einem der vorangehenden Ansprüche,
**dadurch gekennzeichnet, dass**
das Gehäuse (1) wenigstens ein Druckausgleichsventil (45) aufweist, mittels welchem ein Druckausgleich zwischen dem Gehäusehohlraum (4) und der das Gehäuse (1) umgebenden Umgebung durchführbar ist.

26. Kombination umfassend eine Sprechanlageneinheit (10) und eine Unterbauvorrichtung nach einem der vorangehenden Ansprüche,
**dadurch gekennzeichnet, dass**
die Sprechanlageneinheit (10) mittels der Aufsetzhilfseinrichtung (8, 11, 12) derart auf die Halteseite (3) des Gehäuses (1) aufgesetzt ist, dass einerseits der Steckverbinder (5) mit dem Gegensteckverbinder (6) passgenau verbunden ist und andererseits die Zugangsöffnung (7) verschlossen ist.
